# EUROPÄISCHE PATENTANMELDUNG

(11) **EP 1 093 199 A1**
(43) Veröffentlichungstag der Anmeldung: **18.04.2001**
(21) Anmeldenummer: 00113737.1
(22) Anmeldetag: 29.06.2000
(51) Int. Cl.: H02B 1/56, H05K 7/20

(54) **Elektrische Schaltanlage**

(30) Priorität: 15.10.1999 DE 19949873
(71) Anmelder: ALSTOM Power Conversion GmbH, 12277 Berlin (DE)
(72) Erfinder: Jacobs, Helmuth, 51429 Bergisch-Gladbach (DE)
(74) Vertreter: Dreiss, Fuhlendorf, Steimle & Becker

(57) **Zusammenfassung**

Es ist eine elektrische Schaltanlage beschrieben, die mit einem wärmeabgebenden Bauteil versehen ist, das in einem geschlossenen Raum (1) untergebracht ist. Außerhalb des geschlossenen Raums (1) ist ein Röhrenkühler (7) vorgesehen, der mit dem geschlossenen Raum (1) verbunden ist und mit diesem einen inneren Luftkreislauf (9) bildet. Außerhalb des geschlossenen Raums (1) bildet der Röhrenkühler (7) eine äußere Luftströmung (10).

## Beschreibung

Die Erfindung betrifft eine elektrische Schaltanlage mit einem wärmeabgebenden Bauteil, das in einem geschlossenen Raum untergebracht ist.

Es sind elektrische Schaltanlagen bekannt, die im Freien in einem Schalthaus untergebracht sind. Derartige Schaltanlagen sind häufig mit wärmeabgebenden Bauteilen versehen, beispielsweise mit Stromrichtern. Die von diesen Bauteilen erzeugte Wärme muß aus dem einen geschlossenen Raum bildenden Schalthaus nach außen an die Luftatmosphäre abgeführt werden. Dies wird dadurch erreicht, daß in dem Schalthaus eine Klimaanlage untergebracht wird, die in bekannter Weise die Wärme aufnimmt und nach außen transportiert.

Eine derartige Klimaanlage verschmutzt schnell. So setzen sich die Lamellenkühler z.B. an den Verdampfern der Klimaanlage aufgrund des geringen Lamellenabstands schnell mit Schmutz zu. Eine Reinigung der Lamellenkühler z.B. mit Bürsten oder Hochdruckreinigern ist kritisch, da die dünnwandigen Lamellen dabei häufig beschädigt werden. Dies alles führt zu häufigen und aufwendigen Wartungsarbeiten, die die an sich schon hohen Kosten der Klimaanlage weiter erhöhen.

Aufgabe der Erfindung ist es, eine elektrische Schaltanlage zu schaffen, die einfach und kostengünstig zu erstellen und zu warten ist.

Bei einer elektrischen Schaltanlage der eingangs genannten Art wird diese Aufgabe durch die Erfindung dadurch gelöst, daß außerhalb des geschlossenen Raums ein Röhrenkühler vorgesehen ist, der mit dem geschlossenen Raum verbunden ist und mit diesem einen inneren Luftkreislauf bildet, und der außerhalb des geschlossenen Raums eine äußere Luftströmung bildet.

Über den erfindungsgemäßen Röhrenkühler wird ein innerer Luftkreislauf gebildet. Über diesen wird die von dem wärmeabgebenden Bauteil erzeugte Wärme aus dem geschlossenen Raum nach außen zu dem Röhrenkühler transportiert. Innerhalb des Röhrenkühlers wird diese Wärme von dem inneren Luftkreislauf an die äußere Luftströmung weitergegeben. Dabei findet jedoch kein Luftaustausch zwischen dem inneren Luftkreislauf und der äußeren Luftströmung statt. Von der äußeren Luftströmung wird die aufgenommene Wärme an die Luftatmosphäre abgegeben. Insgesamt wird damit die von dem wärmeabgebenden Bauteil erzeugte Wärme über den Röhrenkühler aus dem geschlossenen Raum herausgeführt.

Der erfindungsgemäß vorgesehene Röhrenkühler ersetzt damit die Funktion der beim Stand der Technik vorgesehen Klimaanlage. Die Kühlung der Schaltanlage wird also erfindungsgemäß von dem Röhrenkühler übernommen.

Ein erster Vorteil des Röhrenkühlers besteht darin, daß dieser wesentlich kostengünstiger ist als eine Klimaanlage. Schon allein dadurch können erhebliche Kosten eingespart werden.

Ein weiterer Vorteil des Röhrenkühlers besteht in dessen einfacher Wartbarkeit. So weisen die in dem Röhrenkühler vorhandenen Röhren, durch die die Luft geführt wird, wesentlich größere Abmessungen und Abstände zueinander auf als die Lamellen von Klimaanlagen. Dies hat zur Folge, daß der Röhrenkühler nur wenig verschmutzt, und daß er sich vor allem nicht zusetzt. Ebenfalls sind die Röhren des Röhrenkühlers wesentlich stabiler gebaut als die genannten Lamellen. Damit kann der Röhrenkühler ohne weiteres z.B. mit einem Hochdruckreiniger gereinigt werden.

Insgesamt ist der Röhrenkühler äußerst wartungsarm, und ist, sofern überhaupt erforderlich, äußerst einfach zu warten. Dies stellt eine weitere erhebliche Kostenersparnis dar.

Ein weiterer Vorteil des Röhrenkühler ist hinsichtlich der Geräuschbelastung vorhanden.

Beim Stand der Technik erhöht sich die Geräuschbelastung durch die in dem Schalthaus untergebrachte Klimaanlage wesentlich. Zusammen mit der z.B. durch die Stromrichter entstehenden Geräuschbelastung werden beim Stand der Technik häufig durch Vorschriften vorgegebene Grenzwerte überschritten. Dies erfordert aufwendige und kostenintensive Maßnahmen zur Geräuschminderung.

Auch diese Geräuschprobleme sind durch die Erfindung nicht mehr vorhanden. So ist der Röhrenkühler außerhalb des geschlossenen Raums angeordnet. Damit trägt der Röhrenkühler, wenn überhaupt, nur noch geringfügig zur Geräuschbelastung in dem geschlossenen Raum des Schalthauses bei. Die vorgegebenen Grenzwerte können dadurch wesentlich leichter eingehalten werden als beim Stand der Technik.

Ein weiterer Vorteil des Röhrenkühlers besteht darin, daß das wärmeabgebende Bauteil in einem geschlossenen Schaltschrank untergebracht werden kann.

Dies ist beim Stand der Technik nicht möglich. Dort ist die Klimaanlage in dem geschlossenen Raum des Schalthauses untergebracht. Damit darf das wärmeabgebende Bauteil nicht in einem weiteren geschlossenen Raum enthalten sein, da sonst die von dem Bauteil erzeugte Wärme gar nicht von der Klimaanlage abtransportiert werden kann. Dies hat zur Folge, daß das wärmeabgebende Bauteil nicht nur seine Wärme, sondern auch seine Geräuschentwicklung in den gesamten Raum des Schalthauses abstrahlt.

Im Unterschied dazu kann bei der Erfindung das wärmeabgebende Bauteil in einem weiteren geschlossenen Raum, z.B. in einem Schaltschrank untergebracht werden. Dieser weitere geschlossene Raum befindet sich dann seinerseits in dem geschlossenen Raum des Schalthauses. Der weitere geschlossene Raum mit dem wärmeabgebenden Bauteil wird mit dem Röhrenkühler zu dem inneren Luftkreislauf verbunden. Damit strahlt das wärmeabgebende Bauteil seine Wärme nicht mehr in den gesamten geschlossenen Raum des Schalthauses ab. Stattdessen wird die abgestrahlte Wärme von dem inneren Luftkreislauf aus dem weiteren geschlossenen Raum abgeführt.

Ein zusätzlicher Vorteil dieses weiteren geschlossenen Raums, also z.B. des Schaltschranks besteht darin, daß die Geräuschentwicklung des wärmeabgebenden Bauteils nicht oder nur geringfügig in den geschlossenen Raums des Schalthauses gelangt. Dies stellt eine weitere Minderung der Geräuschbelastung in dem Schalthaus dar.

Schließlich ist bei dem erfindungsgemäßen Röhrenkühler kein umweitschädliches Kühlmittel erforderlich, wie dies in einer Klimaanlage üblicherweise enthalten ist. Sollte dabei die Kühlwirkung des Röhrenkühlers nicht ausreichen, so ist es möglich, den inneren Luftkreislauf und/oder die äußere Luftströmung durch einen oder mehrere Ventilatoren zu unterstützen. Diese Ventilatoren können drehzahlgeregelt sein. Damit kann die Lufttempteratur beeinflußt und gegebenenfalls der Energiebedarf gesenkt werden.

Damit wird insgesamt nicht nur die Kühlung des wärmeabgebenden Bauteils durch die Erfindung in einfacher und kostengünstiger Weise erreicht, sondern es ergeben sich zusätzlich wesentliche Vereinfachungen und Kosteneinsparungen im Hinblick auf die Wartbarkeit und die Geräuschminderung des erfindungsgemäßen Röhrenkühlers.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.
- Figur 1: zeigt eine schematische Seitenansicht eines ersten Ausführungsbeispiels einer erfindungsgemäßen elektrischen Schaltanlage, und
- Figur 2: zeigt eine schematische Seitenansicht eines zweiten Ausführungsbeispiels einer erfindungsgemäßen elektrischen Schaltanlage.

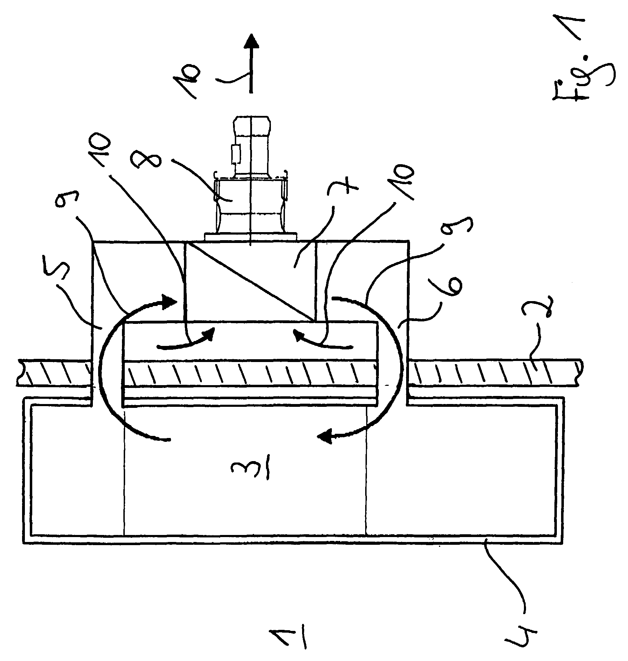

In der Figur 1 ist ein Teil einer ersten Schaltanlage dargestellt, die in einem geschossenen Raum 1 eines Schalthauses untergebracht ist. Der geschlossene Raum 1 wird durch eine Außenwand 2 des Schalthauses begrenzt. Das Schalthaus steht im Freien, so daß sich auf der Außenseite der Außenwand 2 eine normale Luftatmosphäre befindet.

Die Schaltanlage weist zumindest einen Stromrichter 3 auf, der in einem Schaltschrank 4 untergebracht ist. Der Schaltschrank 4 ist an der Außenwand 2 des geschlossenen Raums 1 angeordnet und ist allseitig geschlossen.

In vertikaler Richtung oberhalb des Stromrichters 3 ist ein Abluftrohr 5 und in vertikalter Richtung unterhalb des Stromrichters 3 ist ein Zuluftrohr 6 an den Schaltschrank 4 angeschlossen. Das Abluftrohr 5 und das Zuluftrohr 6 sind durch die Außenwand 2 hindurch aus dem geschlossenen Raum 1 herausgeführt.

Auf der Außenseite der Außenwand 2 sind das Abluftrohr 5 und das Zuluftrohr 6 über einen Röhrenkühler 7 miteinander verbunden. Der Röhrenkühler 7 ist mit Abstand zur Außenwand 2 angeordnet.

Bei dem Röhrenkühler 7 handelt es sich um einen sogenannten Luft-Luft-Röhrenkühler, der derart mit einer Mehrzahl von Röhren versehen ist, daß einerseits Luft durch diese Röhren von dem Abluftrohr 5 zu dem Zuluftrohr 6 strömen kann, und daß andererseits die vorgenannten Röhren von Luft umströmt werden können. Die die Röhren umströmende Luft strömt dabei im wesentlichen quer zu den Röhren durch den Röhrenkühler 7.

Zur Unterstützung dieser Luftströmungen durch den Röhrenkühler 7 ist ein Ventilator 8 vorgesehen, der an dem Röhrenkühler 7 angebracht ist. Dieser Ventilator 8 unterstützt bei dem in der Figur 1 dargestellten Ausführungsbeispiel nicht die Strömung durch die Röhren, sondern die Umströmung der Röhren. Alternativ oder zusätzlich kann der Ventialtor 8 und/oder ein zusätzlicher Ventilator vorgesehen sein, der die Strömung durch die Röhren unterstützt. Der oder die Ventilatoren können drehzahlgeregelt sein.

Auf diese Weise ist bei der in der Figur 1 dargestellten Schaltanlage ein innerer Luftkreislauf 9 vorhanden, bei dem die Luft von dem Stromrichter 3 erwärmt wird, aufgrund dieser Erwärmung zu dem Abluftrohr 5 aufsteigt, über das Abluftrohr 5 zu dem Röhrenkühler 7 gelangt, in dem Röhrenkühler 7 durch dessen Röhren in Richtung zu dem Zuluftrohr 6 weitergeleitet wird, um dann durch das Zuluftrohr 6 hindurch wieder zu dem Stromrichter 3 zu gelangen.

Dieser innere Luftkreislauf 9 ist luftdicht geschlossen. Dies ergibt sich aus dem geschlossenen Schaltschranks 4, den daran angeschlossenen Abluft- und Zuluftrohren 5, 6 und den diese luftdicht verbindenden Röhren des Röhrenkühlers 7. Der innere Luftkreiglauf 9 kann zusätzlich - wie bereits erwähnt - durch einen Ventilator unterstützt werden.

Auf der Außenseite der Außenwand 2 ist bei der in der Figur 1 dargestellten Schaltanlage eine äußerer Luftströmung 10 vorhanden, bei der die Luft von dem Ventilator 8 aus einem Bereich zwischen dem Röhrenkühler 7 und der Außenwand 2 angesaugt und an den Röhren des Röhrenkühlers 7 vorbei wieder an die Luftatmosphäre abgegeben wird.

Diese äußere Luftströmung 10 hat keine Verbindung zu dem inneren Luftkreislauf 9. Der innere Luftkreislauf 9 und die äußere Luftströmung 10 kommen nur indirekt innerhalb des Röhrenkühlers 7 in Kontakt. Dort umströmt die äußere Luftströmung 10 die Röhren, durch die der innere Luftkreislauf 9 hindurchgeführt ist. Ein Luftaustausch zwischen dem inneren Luftkreislauf 9 und der äußeren Luftströmung 10 findet jedoch nicht statt.

In dem Röhrenkühler 7 findet ein Wärmeaustausch zwischen dem inneren Luftkreislauf 9 und der äußeren Luftströmung 10 statt. Dies ergibt sich daraus, daß die von dem Stromrichter 3 erwärmte Luft des inneren Luftkreislaufs 9 die Röhren des Röhrenkühlers 7 erwärmt. Diese Röhren werden von der äußeren Luftströmung 10 umströmt, was zur Folge hat, daß die von den Röhren aufgenommene Wärme über die äußeren Luftströmung 10 wieder von den Röhren des Röhrenkühlers 7 abgeführt wird.

Die über das Zuluftrohr 6 zu dem Stromrichter 3 gelangende Zuluft weist damit eine geringere Temperatur auf als die über das Abluftrohr 5 zu dem Röhrenkühler 7 strömende Abluft. Die Wärmeabgabe des inneren Luftkreislaufs 9 an die Röhren stellt somit eine Kühlung der Luft des inneren Luftkreislaufs 9 dar. Die an die Röhren des Röhrenkühlers 7 abgegebene Wärme wird dann von der äußeren Luftströmung 10 aufgenommen und abgeführt. Dies stellt eine Kühlung der Röhren des Röhrenkühlers 7 dar.

Insgesamt wird damit die von dem Stromrichter 3 erzeugte Wärme über den inneren Luftkreislauf 9 zu dem Röhrenkühler 7 transportiert, und von dort über die äußeren Luftströmung 10 an die Luftatmosphäre abgegeben. Die von dem Stromrichter 3 abgegebene Wärme wird damit über den Röhrenkühler 7 ins Freie abgeleitet.

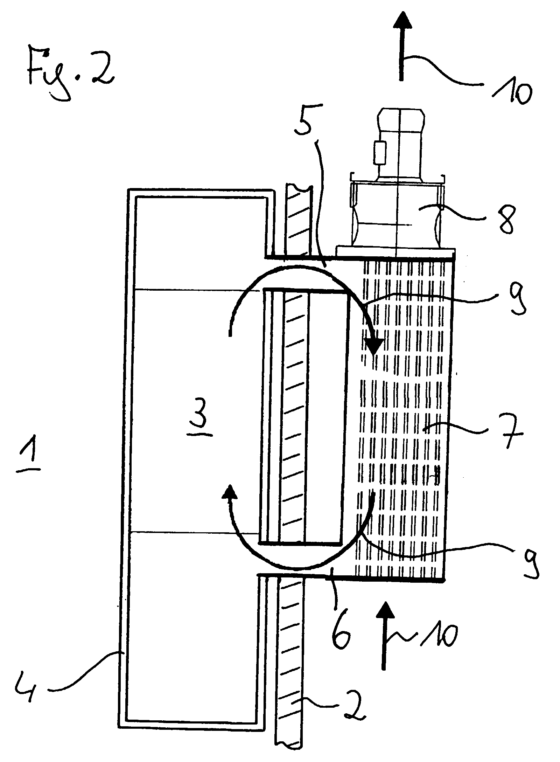

In der Figur 2 ist ein Teil einer zweiten Schaltanlage dargestellt, die im wesentlichen der ersten Schaltanlage der Figur 1 entspricht. Aus diesem Grund sind gleiche Bauteile mit gleichen Bezugszeichen gekennzeichnet.

Ein Unterschied der Figur 2 im Hinblick auf die Figur 1 besteht darin, daß der Ventilator 8 bei der Figur 2 nicht seitlich an dem Röhrenkühler 7 angeordnet ist, wie dies in der Figur 1 der Fall ist, sondern an dem oberen Ende des Röhrenkühlers 7. Damit verläuft die äußere Luftströmung 10 nicht in etwa horizontaler Richtung, wie dies in der Figur 1 der Fall ist, sondern in etwa vertikaler Richtung. Die Luft der äußeren Luftströmung 10 wird bei der Figur 2 am unteren Ende des Röhrenkühlers 7 angesaugt und durch den Röhrenkühler 7 hindurch zu dem Ventilator 8 geführt. Dort wird die Luft an die Luftatmosphäre abgegeben. Innerhalb des Röhrenkühlers 7 der Figur 2 verläuft die Luft des inneren Luftkreislaufs 9 und der äußeren Luftströmung 10 etwa in der gleichen Richtung.

Es versteht sich, daß bei den in den Figuren 1 und 2 gezeigten Röhrenkühlern 7 die Rohren auch zur Führung der äußeren Luftströmung 10 vorgesehen sein können, wobei dann die Röhren von dem inneren Luftkreislauf 9 umströmt sind.

## Patentansprüche

1. Elektrische Schaltanlage mit einem wärmeabgebenden Bauteil, das in einem geschlossenen Raum (1) untergebracht ist, dadurch gekennzeichnet, daß außerhalb des geschlossenen Raums (1) ein Röhrenkühler (7) vorgesehen ist, der mit dem geschlossenen Raum (1) verbunden ist und mit diesem einen inneren Luftkreislauf (9) bildet, und der außerhalb des geschlossenen Raums (1) eine äußere Luftströmung (10) bildet.

2. Schaltanlage nach Anspruch 1, dadurch gekennzeichnet, daß der Röhrenkühler (7) ein Luft-Luft-Röhrenkühler ist.

3. Schaltanlage nach einem der Ansprüche 1 oder 2, dadurch gekennzeichnet, daß der Röhrenkühler (7) an einer den geschlossenen Raum (1) begrenzenden Außenwand (2) angeordnet ist.

4. Schaltanlage nach einem der Ansprüche 1 bis 3, dadurch gekennzeichnet, daß das wäremeabgebende Bauteil in einem Schaltschrank (4) untergebracht ist, der über ein Abluftrohr (5) und ein Zuluftrohr (6) mit dem Röhrenkühler (7) verbunden ist.

5. Schaltanlage nach Anspruch 2, dadurch gekennzeichnet, daß der Schaltschrank (4) in dem geschlossenen Raum (1) untergebracht ist.

6. Schaltanlage nach einem der Ansprüche 1 bis 5, dadurch gekennzeichnet, daß das wärmeabgebende Bauteil ein Stromrichter (3) ist.

7. Schaltanlage nach einem der Ansprüche 1 bis 6, dadurch gekennzeichnet, daß ein Ventilator (8) vorgesehen ist, der den inneren Luftkreislauf (9) und/oder der äußeren Luftströmung (10) unterstützt.
